# EUROPEAN PATENT APPLICATION

(11) **EP 4 518 629 A1**
(43) Date of publication of application: **05.03.2025**
(21) Application number: 24197177.9
(22) Date of filing: 29.08.2024
(51) Int. Cl.: H10K 59/131, H10K 59/80

(54) **LIGHT-EMITTING DEVICE AND METHOD FOR MANUFACTURING LIGHT-EMITTING DEVICE**

(30) Priority: 31.08.2023 JP 2023141041
(71) Applicant: CANON KABUSHIKI KAISHA, Tokyo 146-8501 (JP)
(72) Inventor: TANAKA, Kosuke, Tokyo, 146-8501 (JP)
(74) Representative: TBK

(57) **Abstract**

A light-emitting device according to the present invention includes: a pixel region including a plurality of light-emitting elements; and a peripheral region including an electrode terminal for establishing an electrical connection with an external terminal, a first insulation layer arranged on the electrode terminal, and a second insulation layer arranged on the first insulation layer, wherein the electrode terminal includes a first metal layer exposed by a first opening provided in the first insulation layer, an upper surface of an end portion of the first insulation layer is inclined with respect to a bottom surface of the first metal layer, the upper surface of the end portion forming a part of the first opening, the second insulation layer has a second opening in the first opening, and the second insulation layer is in contact with the electrode terminal in the first opening.

## Description

### BACKGROUND OF THE INVENTION

### Field of the Invention

The present invention relates to a light-emitting device and a method for manufacturing a light-emitting device.

### Description of the Related Art

An organic EL element is emerging as the leading player in color display devices in place of a liquid crystal because the organic EL element is a self-emitting element, and shows a fast response time, does not require a backlight, and is small in power consumption. The organic EL element is required to have higher reliability with a trend toward still higher performances (a trend toward higher definition, higher brightness, and higher color purity).

On the other hand, it is known that the organic compounds of the light-emitting materials for use in an organic EL element are low in moisture resistance, hence a dark spot or current leakage is caused by the externally penetrated moisture. Thus, the technology of reducing the penetration of the moisture into the organic EL element inside has been under development. Japanese Patent Application Publication No. 2018-73760 describes the structure, in which deposition and etching of insulation films having different moisture transmittances are performed twice, as the structure of improving the sealing performance at the pad portion for external data output.

With the organic EL (OLED) display device shown in Japanese Patent Application Publication No. 2018-73760, deposition and etching of the insulation film are performed twice in order to suppress the penetration of the moisture at the contact portion (the bonding pad or the ACF pad) with an external circuit. As a result, the yield of the ACF connection may be reduced according to the shape of the pad to be formed, hence the reliability of the pad may be reduced.

### SUMMARY OF THE INVENTION

The present disclosure provides a light-emitting device capable of improving the reliability of pad.

The present invention in its first aspect provides a light-emitting device as specified in claims 1 to 13. The present invention in its second aspect provides a display device as specified in claim 14. The present invention in its third aspect provides a photoelectric conversion device as specified in claim 15. The present invention in its fourth aspect provides an electronic apparatus as specified in claim 16. The present invention in its fifth aspect provides an illumination device as specified in claim 17. The present invention in its sixth aspect provides a moving body as specified in claims 18. The present invention in its seventh aspect provides a device as specified in claim 19. The present invention in its eighth aspect provides an image forming apparatus as specified in claims 20.

The present invention in its ninth aspect provides a method for manufacturing a light-emitting device as specified in claims 21 to 23.

Further features of the present invention will become apparent from the following description of exemplary embodiments with reference to the attached drawings.

### BRIEF DESCRIPTION OF THE DRAWINGS

FIG. 1 is an overall plan view of a light-emitting device in accordance with Example 1;
FIG. 2 is a cross-sectional view at a cut line A of FIG. 1;
FIG. 3 is a cross-sectional view of a pad portion in Example 1;
FIG. 4 is a cross-sectional view before pad opening of FIG. 2;
FIG. 5A is a view for illustrating a manufacturing process of a pad opening in Example 1;
FIG. 5B is a view for illustrating a manufacturing process of the pad opening in Example 1;
FIG. 5C is a view for illustrating a manufacturing process of the pad opening in Example 1;
FIG. 5D is a view for illustrating a manufacturing process of the pad opening in Example 1;
FIG. 5E is a view for illustrating a manufacturing process of the pad opening in Example 1;
FIG. 5F is a view for illustrating a manufacturing process of the pad opening in Example 1;
FIG. 6 is a cross-sectional view of a pad opening of a light-emitting device in accordance with Example 2;
FIG. 7A is a view for illustrating a manufacturing process of the pad opening in Example 2;
FIG. 7B is a view for illustrating a manufacturing process of the pad opening in Example 2;
FIG. 7C is a view for illustrating a manufacturing process of the pad opening in Example 2;
FIG. 7D is a view for illustrating a manufacturing process of the pad opening in Example 2;
FIG. 7E is a view for illustrating a manufacturing process of the pad opening in Example 2;
FIG. 7F is a view for illustrating a manufacturing process of the pad opening in Example 2;
FIG. 8A is a view for illustrating a pixel structure of a display device in accordance with Example 3;
FIG. 8B is a view for illustrating a pixel structure of the display device in accordance with Example 3;
FIG. 9 is a schematic view showing one example of a display device in accordance with one embodiment;
FIG. 10A is a schematic view showing one example of an image pick-up device in accordance with one embodiment;
FIG. 10B is a schematic view showing one example of electronic equipment in accordance with one embodiment;
FIG. 11A is a schematic view showing one example of a display device in accordance with one embodiment;
FIG. 11B is a schematic view showing one example of a display device in accordance with one embodiment;
FIG. 12A is a schematic view showing one example of an illumination device in accordance with one embodiment;
FIG. 12B is a schematic view showing one example of an illumination device in accordance with one embodiment;
FIG. 13A is a schematic view showing one example of a wearable device in accordance with one embodiment;
FIG. 13B is a schematic view showing one example of a wearable device in accordance with one embodiment;
FIG. 14A is a schematic view of an image forming apparatus in accordance with one embodiment;
FIG. 14B is a schematic view of an image forming apparatus in accordance with one embodiment; and
FIG. 14C is a schematic view of an image forming apparatus in accordance with one embodiment.

### DESCRIPTION OF THE EMBODIMENTS

Below, referring to the accompanying drawings, an embodiment for carrying out the present invention will be described. Incidentally, in the following description and drawings, a common configuration among a plurality of drawings are given a common reference numeral and sign. For this reason, the common configuration will be described with cross-reference to a plurality of drawings, and a description on the configuration given a common reference numeral and sign will be appropriately omitted.

### Example 1

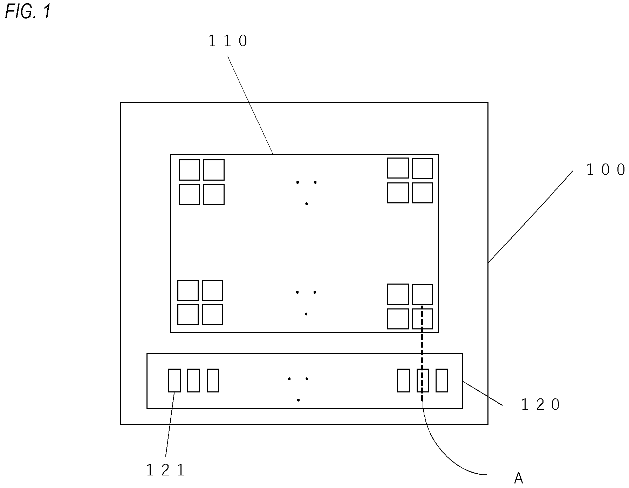

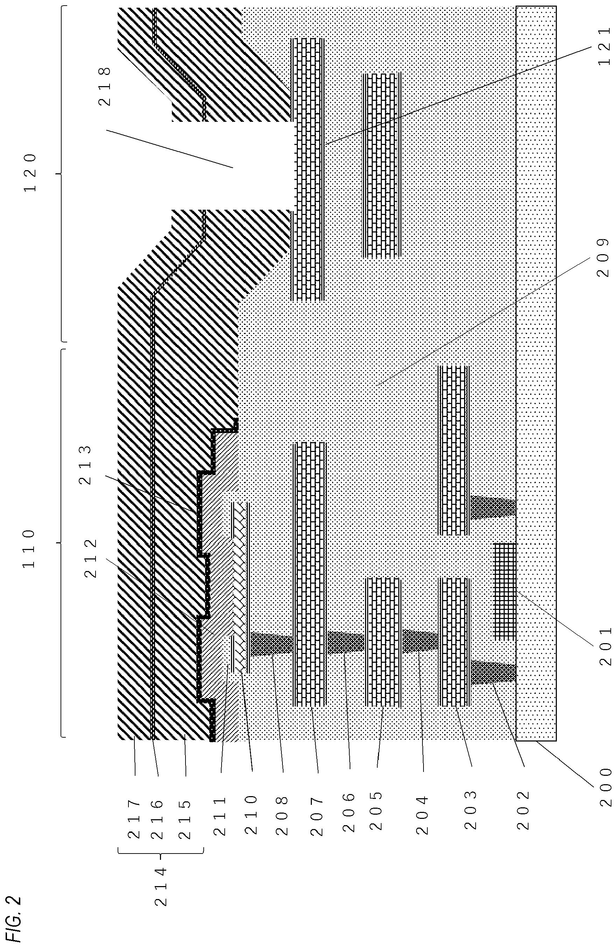

FIG. 1 is a plan view of an organic EL display device 100 to which the present invention is applied, and FIG. 2 is a cross-sectional view of the display device 100 at a cut line A. The display device 100 has a pixel array (pixel region) 110 where pixels including a plurality of light-emitting elements are arranged, and a pad arrangement region 120 where pads (electrode terminals) for electrically connecting the pixel of the display device 100 with an external terminal are arranged. The pad arrangement region 120 is also referred to as a peripheral region. The pixel array 110 and the pad arrangement region 120 are arranged on a silicon substrate 200.

The pixel array 110 has a plurality of organic light-emitting layers 212, and a plurality of transistors 201 and wiring layers 203, 205, and 207 for driving them. Respective wiring layers are connected by plugs 204, 206, and 208. Further, the pixel array 110 has a plug 202 for connecting the wiring layer 203 to the silicon substrate 200. An insulation layer 209 is arranged between the wiring layers 203, 205, and 207 and the plugs 202, 204, 206, and 208.

The silicon substrate 200 is, for example, a single crystal silicon layer having a thickness of 750 to 800 *µ* m, and preferably 770 to 780 µm.

The pixel array 110 includes an upper electrode 213 and a lower electrode 210 for applying a voltage to the organic light-emitting layer 212 on and under the organic light-emitting layer 212, respectively. The lower electrode 210 is connected with the wiring layer 207 by the plug 208. A sealing layer 214 for ensuring the life is arranged on the organic light-emitting layer 212. The sealing layer 214 can be arbitrarily selected from among the materials generally used in a semiconductor device. For example, a silicon nitride film that is a light-transmissive and dense film, or the like is used as the material for the sealing layer 214. Further, the sealing layer 214 has a 3-layered structure in which an oxide film layer is sandwiched between insulation layers. Specifically, the sealing layer 214 includes a first sealing layer 215, a second sealing layer 216, and a third sealing layer 217. The first sealing layer 215 and the third sealing layer 217 are each, for example, a silicon nitride film (SiN) deposited by a plasma CVD (Chemical Vapor Deposition) method. For the second sealing layer 216, an alumina film (Al₂O₃) deposited with the ALD method can be used.

The transistor 201 can be formed by a known semiconductor process technology. The contact plug 202 can include a high-melting-point metal such as tungsten. The wiring layers 203, 205, and 207 each presumably have a configuration by an aluminum wire and a tungsten plug. However, a copper material may be used. The insulation layer 209 can include a silicon type insulation film such as a silicon oxide film, a silicon nitride film, or a silicon carbide film. Further, a Low-k material with a low dielectric constant, or the like may be included therein.

In order to electrically connect the display device 100 with the outside, a pad opening 218 is arranged in the pad arrangement region 120, and a pad electrode 121 is arranged at the bottom of the pad opening 218. For the pad electrode 121, a metal material such as aluminum is used. The pad electrode 121 is configured by exposure of the metal layer by the pad opening 218. In the present Example, the pad electrode 121 is formed simultaneously with the wiring layer 207. In other words, the pad electrode 121 and the wiring layer 207 have roughly the same film configuration and film thickness. However, at the time of forming the pad opening 218, the film thickness at the pad opening 218 portion in the pad electrode 121 can be smaller as compared with that outside the opening.

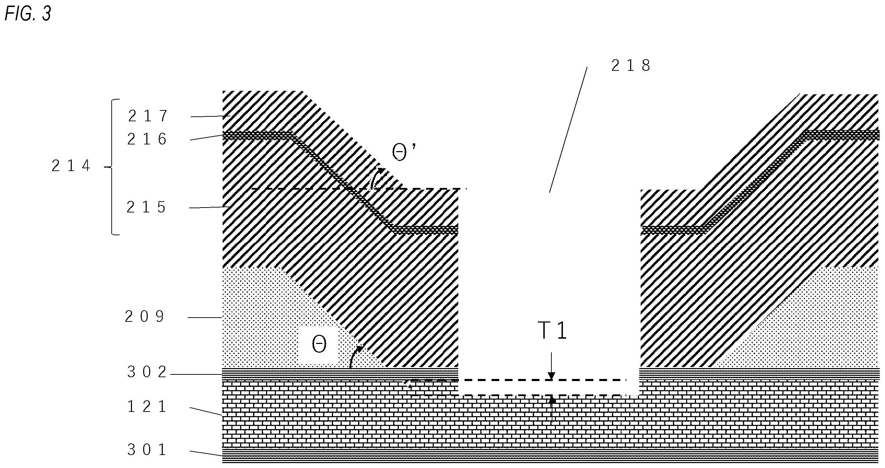

FIG. 3 shows a cross-sectional view of the pad portion on an enlarged scale. A second metal layer 302 is arranged at the overlying layer of the pad electrode 121 (first metal layer). The second metal layer 302 is also referred to as a barrier metal, and for example, titanium or titanium nitride can be used.

On the second metal layer 302, an insulation layer 209, i.e., a first insulation layer is arranged. On the first insulation layer, a sealing layer 214, i.e., the second insulation layer is arranged. Incidentally, in the present disclosure, the configuration in which the second insulation layer is arranged on the first insulation layer includes the case where the second insulation layer is arranged in contact with the first insulation layer, and the case where the first insulation layer and the second insulation layer are arranged so that one or a plurality of third insulation layers may be included between the first insulation layer and the second insulation layer.

For the insulation layer 209, for example, a silicon oxide film deposited with the plasma CVD method can be used. The upper surface of the insulation layer 209 is in a shape with an inclination with respect to the pad electrode 121 at the end portion of the pad opening 218 side. The inclination of the insulation layer 209 is the inclination such that the film thickness becomes thinner as the insulation layer 209 approaches the pad opening 218. Further, the insulation layer 209 is arranged away from the pad opening 218, and the insulation layer 209 is not adjacent to the pad opening 218. Herein, the angle of inclination of the insulation layer 209 surface with respect to the pad electrode 121 is referred to as Θ. By forming the opening by isotropic etching with respect to the insulation layer 209, it is possible to form a shape including the inclination at the end portion of the insulation layer 209. The angle of inclination Θ can be controlled to a certain degree according to the processing conditions for isotropic etching. Further, the inclination may be in a shape of not a plane but a curved surface according to the processing conditions for isotropic etching.

The sealing layer 214 is arranged on the insulation layer 209. The sealing layer 214 extends from the pixel array 110, and includes 3 layers of the first sealing layer 215, the second sealing layer 216, and the third sealing layer 217 as with the portion of the pixel array 110. The sealing layer 214 is in a shape having a portion with an inclination with respect to the pad electrode 121 in the vicinity of the pad opening 218. The sealing layer 214 is in such a shape because it is deposited on the inclination of the insulation layer 209. Herein, the angle of inclination of the sealing layer 214 surface with respect to the pad electrode 121 is referred to as Θ'. Further, in the region adjacent to the pad opening 218, the upper surface of the sealing layer 214 is not inclined, and is in parallel with the pad electrode 121. Further, in this region (in the first opening described later), the insulation layer 209 is not arranged between the sealing layer 214 and the second metal layer 302, and the sealing layer 214 is arranged in contact with the top of the second metal layer 302.

The side surface (inclined surface) of the pad opening 218 of the insulation layer 209 is covered with the sealing layer 214, and the insulation layer 209 is not exposed. By reducing the penetration of the moisture with the insulation layer 209 as the path, it is possible to prevent the deterioration of light-emitting layer 212, and to reduce the deficiency such as poor light emission.

The angle of inclination Θ of the insulation layer 209 is preferably set at at least 20 degrees and not more than 50 degrees. This is because the possibility of occurrence of a void at the time of deposition of the sealing layer 214 is low when the inclination of the insulation layer 209 is the foregoing. If a void occurs, the target site becomes the penetration path for the moisture, and the light-emitting layer is degraded, thereby causing the occurrence of the deficiency such as poor light emission. For this reason, in the present disclosure, the inclination of the insulation layer 209 is loosened, thereby reducing the fear of the occurrence of a void in the sealing layer 214. However, when the inclination of the insulation layer 209 is made too small, the dimensions of the pad opening 218 undesirably increase. Thus, by setting the angle of inclination Θ of the insulation layer 209 at at least 20 degrees and not more than 50 degrees, it is possible to combine the suppression of a void and the miniaturization of the pad opening 218.

The insulation layer 209 is inclined. For this reason, the same inclination is also caused at the time of forming the overlying sealing layer 214. Formation in such a shape facilitates entry of a conductive particle into the pad opening 218 at the time of bonding when an anisotropic conductive film (ACF) is used at the time of mounting. This can provide an effect of improving the yield. However, when the inclination is made too small, the dimensions of the pad opening 218 undesirably increase. By setting the angle of inclination O' of the sealing layer 214 at at least 20 degrees and not more than 50 degrees, it is possible to combine the improvement of the yield and the miniaturization of the pad opening 218. The angle of inclination O' may be the same angle as the angle of inclination Θ, or may be a different angle therefrom.

The sidewall of the pad opening 218 includes the exposed sealing layer 214 and second metal layer 302, and a pad electrode 121 is arranged at the bottom surface of the pad opening 218. The insulation layer 209 is arranged retreating from the pad opening 218, and hence, the insulation layer 209 will not be exposed at the sidewall of the pad opening 218. The pad opening 218 is formed with respect to the sealing layer 214 using anisotropic etching. At this step, the second metal layer 302 functions as an etching stop layer. Even when the film thickness of the sealing layer 214 varies, it becomes possible to minimize the etched amount of the pad electrode 121. The pad electrode 121 is cut off by etching. For this reason, the pad electrode 121 has a concave portion at the portion of the pad opening 218, which is thinner than the portion other than the pad opening 218. The depth T1 of the concave portion is, for example, at least 1 nm and not more than 100 nm.

Such a structure enables the suppression of excessive etching of the pad electrode 121, which minimizes the corrosion of the pad due to the moisture immersion at the post-step mounting step. As a result, it is possible to suppress the degradation of the reliability of the pad.

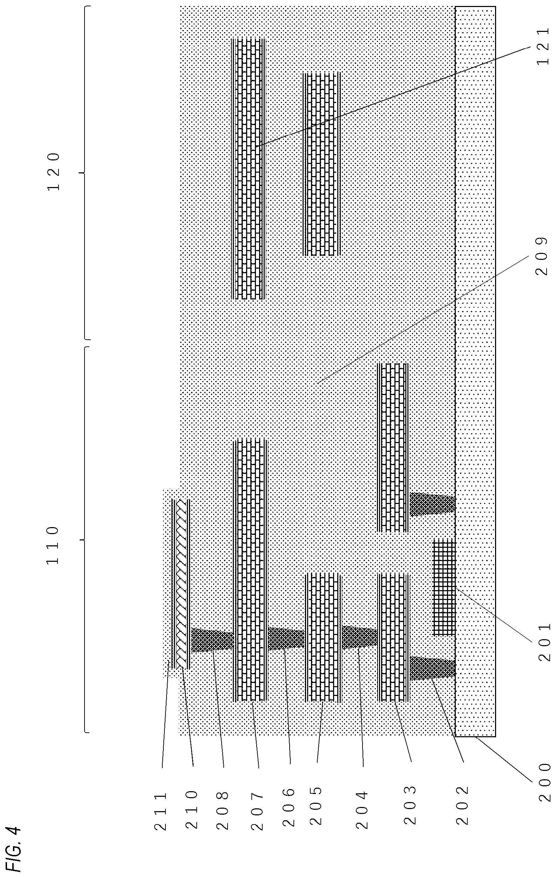

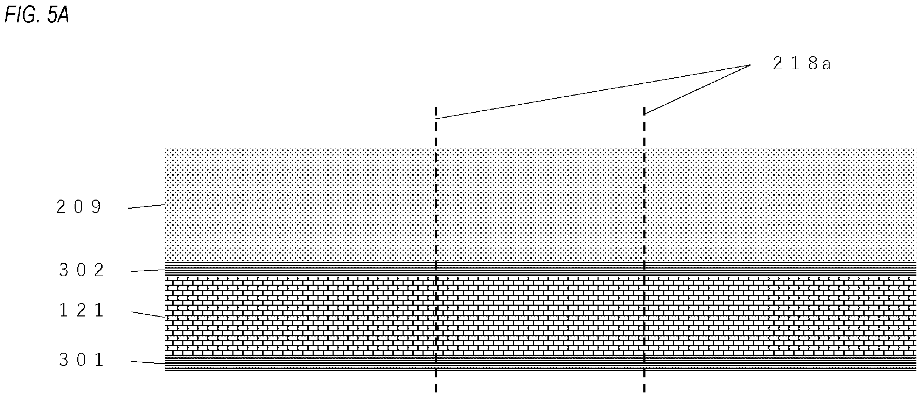

Below, referring to FIGS. 4, and 5A to 5F, a method for manufacturing the display device 100 of the present disclosure will be described. Each drawing shows a cross-sectional view at east step until the formation of the pad opening 218 for connecting the pad electrode 121 to the outside.

FIG. 4 is a view showing the cross-sectional structure before the pad opening. Of the structure shown in FIG. 1, the pixel array 110 has been formed up to the lower electrode 210 and the insulation layer 211, and the pad arrangement region 120 has been formed up to the insulation layer 209. Manufacturing by the manufacturing method up to the step of FIG. 4 can be accomplished by the conventionally and commonly used method.

FIGS. 5A to 5F are each a view for illustrating the process flow of the pad opening, and are each a view of the pad arrangement region 120 of FIG. 1 or FIG. 4 on an enlarged scale. FIG. 4 and FIG. 5A are views showing the state after the same step.

First, as shown in FIG. 5A, on the pad electrode 121, a second metal layer 302 is arranged, and an insulation layer 209 is deposited at the overlying layer thereof. These are formed simultaneously with the pixel array 110. The pad electrode 121 includes, for example, a metal portion of the material including copper (Cu) in an amount of 5 wt% based on the amount of aluminum (Al). The second metal layer 302 includes, for example, a metal portion of titanium nitride (TiN). Further, a barrier metal 301 may be arranged under the pad electrode 121. For the barrier metal 301, for example, titanium (Ti), or titanium nitride (TiN) is used. For the insulation layer 209, for example, a silicon oxide film (SiO) deposited by a plasma CVD method is used.

A pad opening boundary 218a indicates the position of the pad opening 218 provided at a later step.

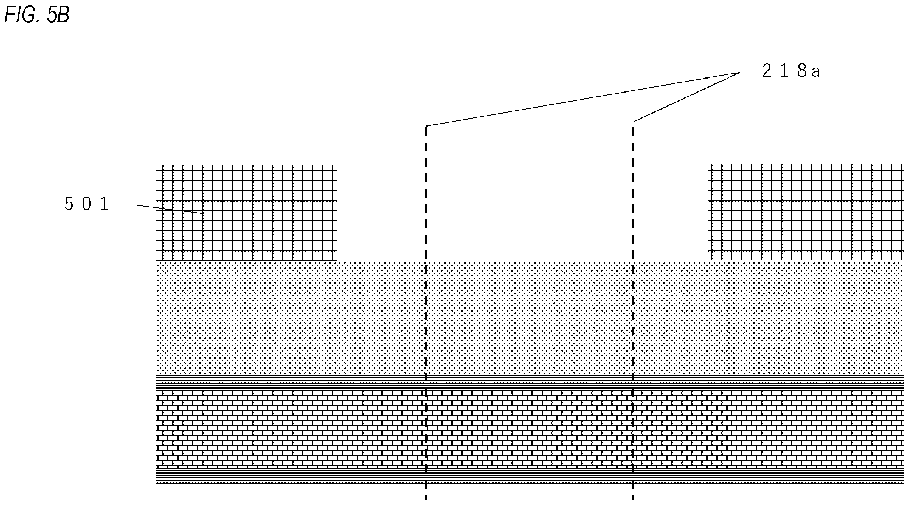

Then, as shown in FIG. 5B, using the photolithographic method, the insulation layer 209 is etched, thereby forming a photoresist 501 as a protective film for forming an opening (which is referred to as a first opening). The photoresist 501 has an opening at a position retreating from the pad opening boundary 218a.

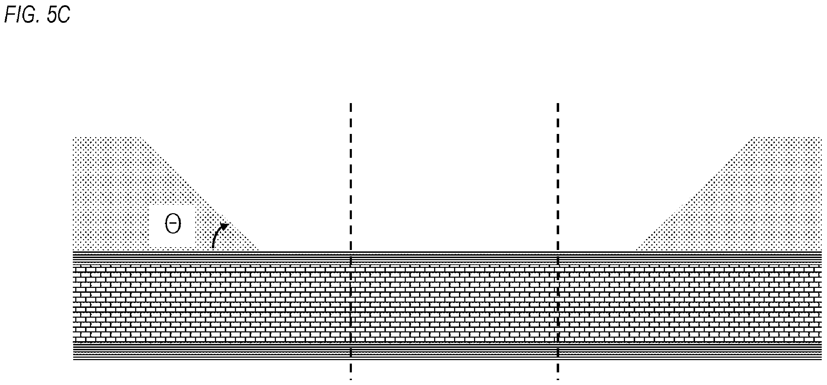

Subsequently, as shown in FIG. 5C, an opening (a first opening) is formed in the insulation layer 209 by isotropic etching. Processing by isotropic etching makes the insulation layer 209 have a shape having an inclination with respect to the pad electrode 121 at the end portion on the side of the first opening. By using, for example, wet etching with buffered hydrofluoric acid for isotropic etching, it is possible to leave behind the second metal layer 302 with ease, which enables prevention of exposure of the pad electrode 121. Isotropic dry etching may be used so long as the second metal layer 302 can be left behind. The photoresist 501 has an opening at a position retreating from the pad opening boundary 218a. For this reason, the opening (the first opening) of the insulation layer 209 is formed retreating from the pad opening boundary 218a. After forming the opening (the first opening) in the insulation layer 209, the photoresist 501 is removed.

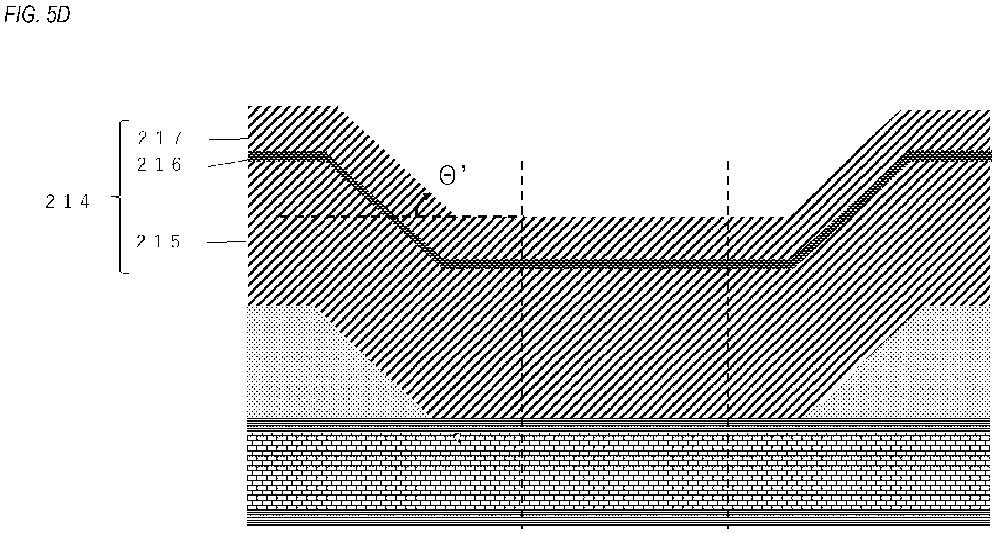

Then, as shown in FIG. 5D, a sealing layer 214 is deposited at the overlying layer of the insulation layer 209 and the opening (the first opening) of the insulation layer 209. The sealing layer 214 is also deposited at the pixel array 110 at the same time. The sealing layer 214 is, for example, a silicon nitride film deposited by a plasma CVD method, and includes 3 layers including an alumina film (Al₂O₃) deposited by the ALD (Atomic Layer Deposition) method in between. The sealing layer 214 can function as a blocking film against the external moisture by adopting a film with a smaller moisture transmittance than that of the insulation layer 209. Further, the presence of the inclination at the end portion of the insulation layer 209 can reduce the fear of occurrence of a void in deposition of the sealing layer 214. Further, the sealing layer 214 is also deposited with the same inclination along the inclination at the opening of the insulation layer 209. As a result of this, for example, at the time of bonding of an anisotropic conductive film (ACF), a conductive particle becomes more likely to enter the pad opening 218, which can also provide the effect of the improvement of the yield.

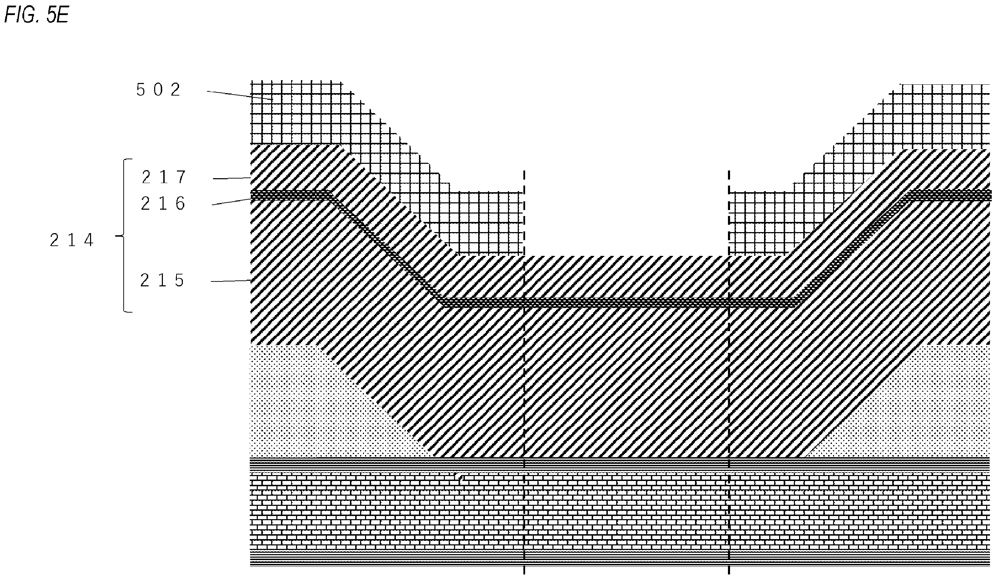

Then, as shown in FIG. 5E, a photoresist 502 is formed on the top of the sealing layer 214 using the photolithographic method. The photoresist 502 functions as a protective film for etching the sealing layer 214, and forming an opening (which is referred to as a second opening). The opening of the photoresist 502 is assumed to have the configuration in rough agreement with that of the pad opening boundary 218a.

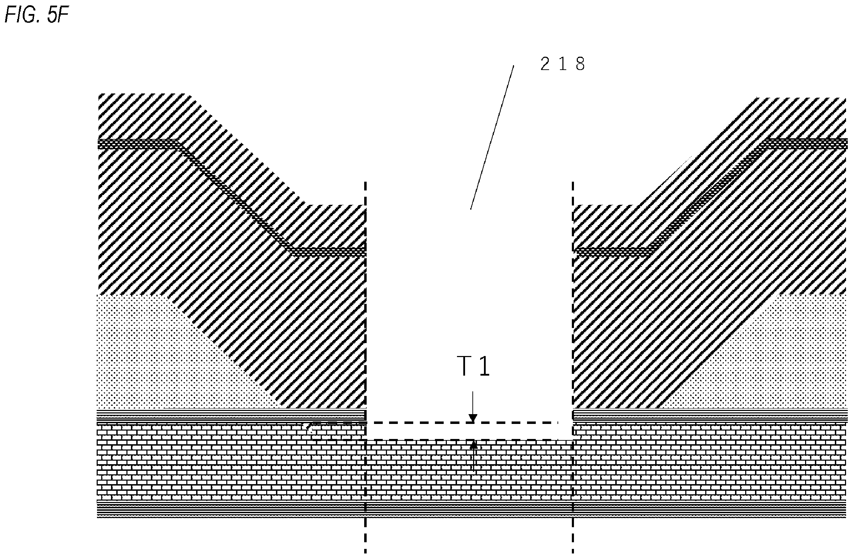

Then, as shown in FIG. 5F, the opening (the second opening) is formed in the sealing layer 214 by anisotropic etching, and the second metal layer 302 is removed to expose the pad electrode 121. For anisotropic etching, for example, plasma etching (RIE) by a C₄F₈ or CF₄ type gas can be used. At this step, the insulation layer 209 is formed retreating from the pad opening 218. This results in a structure in which the sidewall of the pad opening 218 is covered with the sealing layer 214. Such a structure enables the reduction of the penetration of the moisture with the portion of from the pad opening 218 to the insulation layer 209 as the path, which can reduce the degradation of the light-emitting layer 212, and can reduce deficiencies such as poor light emission. Subsequently, the photoresist 502 is removed, resulting in the completion of the pad opening 218.

As apparent from the comparison with the conventional technology, in which the pad electrode 121 is exposed at the opening to two etchings of the insulation layer 209 and the sealing layer 214, in the present Example, exposure is to implement with only one etching of the sealing layer 214. In contrast, in the present Example, exposure is to implement only one etching of the sealing layer 214. Therefore, it is possible to implement the reduction of the etched amount (the depth T1 of the concave portion) of the pad electrode 121. As a result of this, it is possible to obtain high reliability with respect to, for example, the corrosion of the pad electrode 121 due to immersion in water for a long time at the dicing step of the mounting process.

### Example 2

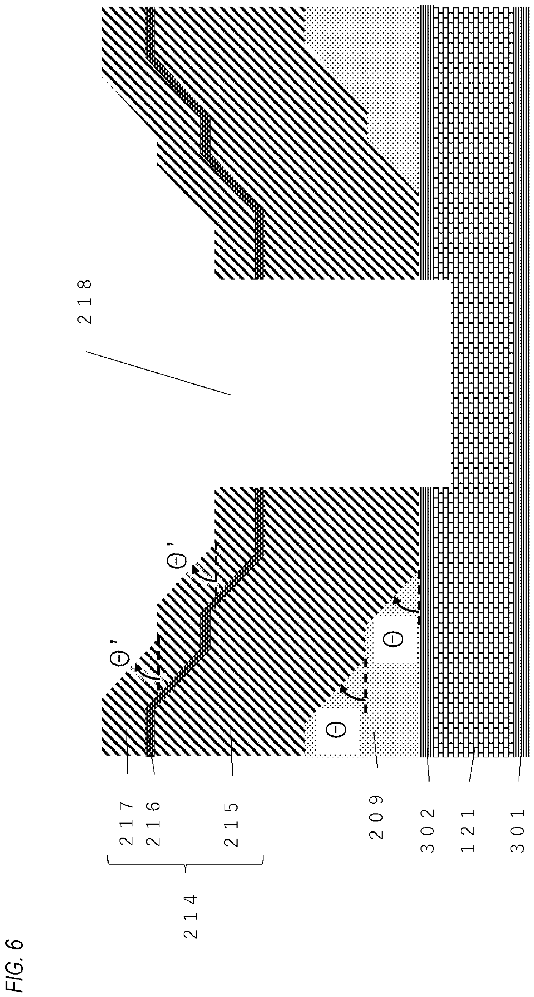

FIG. 6 is a cross-sectional view of Second Example. The difference from First Example is in that the inclination of the insulation layer 209 includes 2 steps, and in that the sealing layer 214 deposited on the overlying layer thereof is also in a shape having the same inclination. The insulation layer 209 has a first inclined portion with the upper surface inclined with respect to the pad electrode 121, a parallel portion with the upper surface in parallel with the pad electrode 121, and a second inclined portion with the upper surface inclined with respect to the pad electrode 121. The inclination of the insulation layer 209 including two steps enables the more reduction of the fear of occurrence of a void in the sealing layer 214 at the step portion. Further, the inclination of the sealing layer 214 including 2 steps makes a charged particle more likely to enter the pad opening at the time of bonding when an anisotropic conductive film (ACF) is used at the time of mounting. This can provide an effect of improving the yield. Although the present Example shows the example in which all the angles of inclination of the insulation layer 209 is Θ, it is also possible to change the angle of inclination.

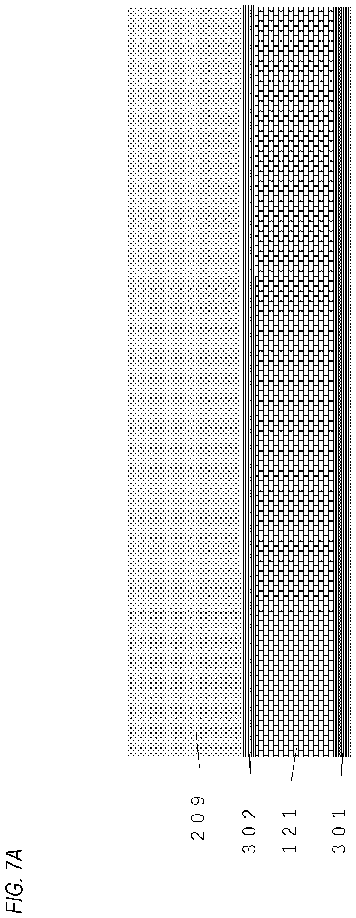

Referring to FIGS. 7A to 7F, the formation method of Second Example will be shown.

First, as shown in FIG. 7A, on the pad electrode 121, the second metal layer 302 is arranged, and the insulation layer 209 is deposited at the overlying layer thereof.

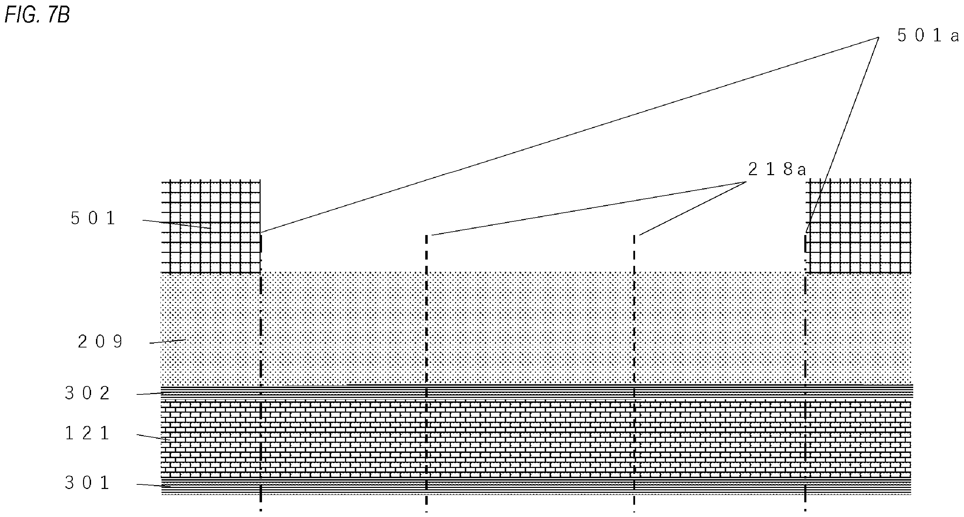

Then, as shown in FIG. 7B, as a protective film for etching the insulation layer 209 using the photolithographic method, a photoresist 501 is formed. The photoresist 501 has an opening at a position retreating from the pad opening boundary 218a. Herein, the end portion of the opening of the photoresist 501 is referred to as a photoresist opening boundary 501a. The procedure up to this point is the same as that of First Example.

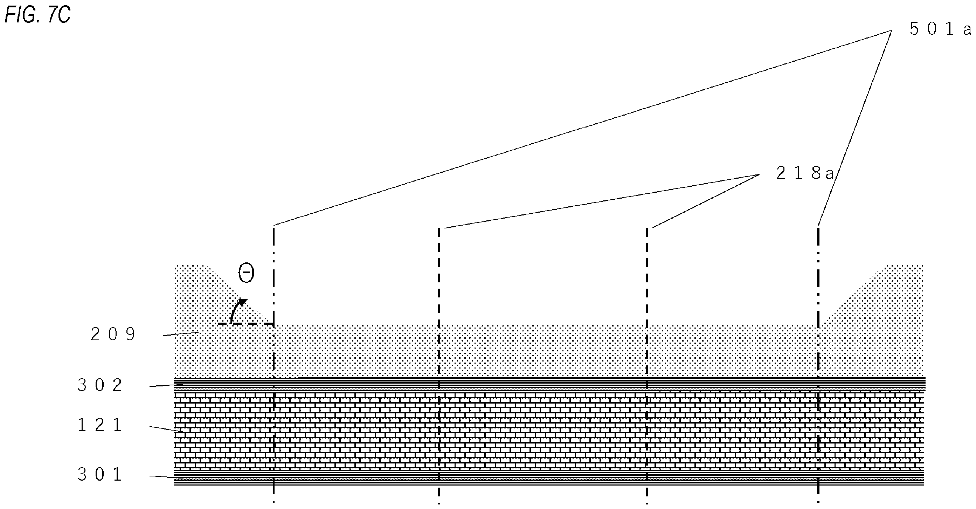

Subsequently, as shown in FIG. 7C, the insulation layer 209 is subjected to isotropic etching. The difference from First Example is in that etching is stopped at the midpoint of the insulation layer 209. Processing with isotropic etching causes the insulation layer 209 to have a shape having an angle of inclination Θ with respect to the pad electrode 121. After etching the insulation layer 209, the photoresist 501 is removed.

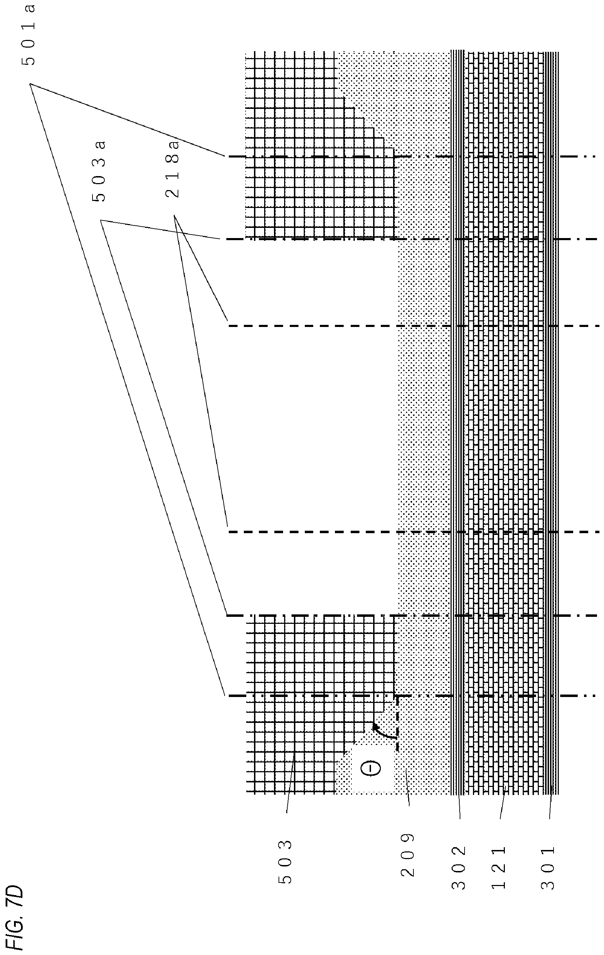

Then, as shown in FIG. 7D, as the protective film for further etching the insulation layer 209 using the photolithographic method, and forming an opening, a photoresist 503 is formed. Herein, the end portion of the opening of the photoresist 503 is referred to as a photoresist opening boundary 503a. The photoresist opening boundary 503a is characterized by being situated between the pad opening boundary 218a and the photoresist opening boundary 501a.

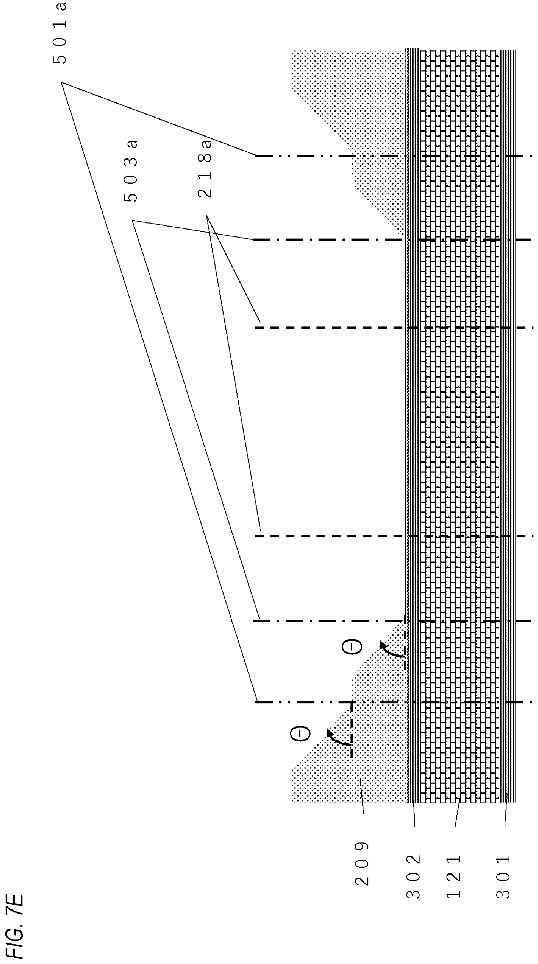

Then, as shown in FIG. 7E, the insulation layer 209 is further subjected to isotropic etching, thereby forming an opening. The photoresist opening boundary 503a is situated between the pad opening boundary 218a and the photoresist opening boundary 501a. For this reason, a portion having an angle of inclination Θ is formed inside the inclined portions formed in FIG. 7C. By performing such processing, it is possible to manufacture a structure in which the inclination of the insulation layer 209 includes 2 steps. The present Example shows the case where two isotropic etchings are performed under the same conditions, so that the angle of inclinations of the two steps become equal to each other. However, by using different conditions, it is also possible to set the angle of inclinations of the two steps at different angles to some extent. Further, by increasing the number of isotropic etchings, it is also possible to provide an inclination of 3 steps or more.

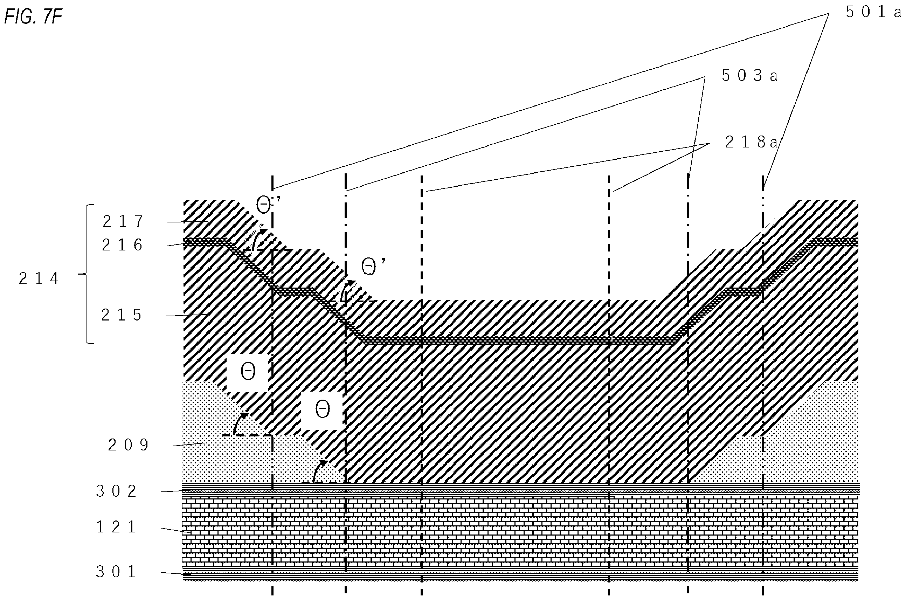

Then, as shown in FIG. 7F, a sealing layer 214 is deposited on the overlying layer of the insulation layer 209 and the opening of the insulation layer 209. The insulation layer 209 has an inclination of 2 steps. For this reason, 2 steps are also formed at the sealing layer 214. Herein, the angle of inclination of the sealing layer 214 is referred to as O'.

From this point forward, a pad opening 218 is formed in the same manner as in First Example.

Such a manufacturing method enables the formation of the structure as with that of Second Example.

### Example 3

Another example of an organic EL device having a sealing structure of the same pad opening portion as that of the Example will be described.

### Configuration of Organic EL Light-Emitting Element

An organic EL light-emitting element is provided by forming an insulation layer, a first electrode, an organic compound layer, and a second electrode formed on a substrate. A protective layer, a color filter, a microlens, and the like may be provided on a cathode. When a color filter is provided, a planarization layer may be provided between the color filter and the protective layer. The planarization layer can include an acrylic resin, or the like. The same also applies to the case where the planarization layer is provided between the color filter and the microlens.

### Substrate

As the substrate, mention may be made of quartz, glass, a silicon wafer, a resin, a metal, or the like. Further, on the substrate, a switching element such as a transistor and a wire are provided, and an insulation layer may be provided thereon. Any material is acceptable for the insulation layer so long as a contact hole can be formed so that wiring can be formed between the insulation layer and the first electrode, and so long as insulation from wires not to be connected can be ensured. For example, a resin such as polyimide, silicon oxide, or silicon nitride can be used.

### Electrode

For the electrodes, a pair of electrodes can be used. A pair of electrodes may be an anode and a cathode. When an electric field is applied in the direction of light emission of an organic light-emitting element, the electrode with a higher electric potential is the anode, and the other is the cathode. Alternatively, it can also be said that the electrode for supplying holes to the light-emitting layer is the anode, and that the electrode for supplying electrons is the cathode.

The constituent material for the anode desirably has a work function as large as possible. For example, a metal simple substance such as gold, platinum, silver, copper, nickel, palladium, cobalt, selenium, vanadium, or tungsten, a mixture including the same, or an alloy of a combination thereof can be used. Further, metal oxides such as tin oxide, zinc oxide, indium oxide, indium tin oxide (ITO), and indium zinc oxide can be used. Further, conductive polymers such as polyaniline, polypyrrole, and polythiophene can be used.

The electrode substances may be used singly alone, or in combination of two or more thereof. Further, the anode may be formed of a monolayer, or may be formed of a plurality of layers.

In the case of use as a reflective electrode, for example, chromium, aluminum, silver, titanium, tungsten, or molybdenum, or an alloy thereof, or a lamination thereof can be used. The material can also function as a reflective film not having a role as an electrode. Whereas, in the case of use as a transparent electrode, an oxide transparent conductive layer of indium tin oxide (ITO), indium zinc oxide, or the like, or other materials can be used. However, the present invention is not limited thereto. For the formation of the electrode, the photolithographic technology can be used.

On the other hand, the constituent material for the cathode desirably has a small work function. Examples thereof may include an alkali metal such as lithium, an alkaline-earth metal such as calcium, a metal simple substance such as aluminum, titanium, manganese, silver, lead, or chromium, or a mixture including these. Alternatively, an alloy of a combination of the metal simple substances can be used. For example, magnesium-silver, aluminum-lithium, aluminum-magnesium, silver-copper, or zinc-silver can be used. A metal oxide such as indium tin oxide (ITO) can also be used. The electrode substances may be used singly alone, or in combination of two or more thereof. Further, the cathode may be formed of a monolayer, or may be formed of a multilayer. Out of these, silver is preferably used. In order to reduce the aggregation of silver, a silver alloy is further preferable. When the aggregation of silver can be reduced, the ratio of the alloy does not matter. For example, silver : other metals may be 1 : 1, 3 : 1, or the like.

The cathode may be a top emission element using an oxide conductive layer such as ITO, or may be a bottom emission element using a reflective electrode such as aluminum (Al), and has no particular restriction. The formation method of the cathode has no particular restriction. Use of a direct-current or alternating-current sputtering method, or the like is more preferable because the coverage of the film is good, and the resistance tends to be reduced.

### Pixel Isolation Layer

A pixel isolation layer is formed of a silicon nitride (SiN) film, a silicon oxynitride (SiON) film, or a silicon oxide (SiO) film formed using the chemical vapor deposition method (CVD method). In order to increase the resistance in the in-plane direction of the organic compound layer, the film thickness of the organic compound layer, particularly, the hole transport layer is preferably deposited thinly at the sidewall of the pixel isolation layer. Specifically, by increasing the taper angle of the sidewall of the pixel isolation layer, and the film thickness of the pixel isolation layer, and increasing the vignetting at the time of vacuum evaporation, it is possible to achieve deposition with a thin film thickness of the sidewall.

On the other hand, the pixel isolation layer is preferably adjusted on the taper angle of the sidewall of the pixel isolation layer or the film thickness of the pixel isolation layer to such an extent as to prevent the formation of a void in the protective layer to be formed thereon. A void is not formed in the protective layer. For this reason, it is possible to reduce the occurrence of a deficiency in the protective layer. The occurrence of a deficiency in the protective layer is reduced. For this reason, it is possible to reduce the reliability degradation due to the occurrence of a dark spot or the poor conduction of the second electrode.

In accordance with the present Example, even when the taper angle of the sidewall of the pixel isolation layer is not steep, it becomes possible to effectively suppress the electric charge leakage to the adjacent pixel. As a result of the present study, it has been indicated that a taper angle within the range of at least 60 degrees and not more than 90 degrees can sufficiently achieve the reduction. The film thickness of the pixel isolation layer is desirably at least 10 nm and not more than 150 nm. Further, even the configuration including only the pixel electrode not having the pixel isolation layer can provide the same effect. However, in this case, the film thickness of the pixel electrode is preferably set at half of the thickness of the organic layer or smaller, or the pixel electrode end is set as a forward tapered shape of less than 60° because the short circuit of the organic light-emitting element can be reduced.

### Organic Compound Layer

The organic compound layer may be formed of a monolayer, or may be formed of a plurality of layers. When the organic compound layer has a plurality of layers, it may be referred to as a hole injection layer, a hole transport layer, an electron blocking layer, a light-emitting layer, a hole blocking layer, an electron transport layer, or an electron injection layer according to the function thereof. The organic compound layer mainly includes an organic compound, and may include an inorganic atom, or an inorganic compound. The organic compound may have, for example, copper, lithium, magnesium, aluminum, iridium, platinum, molybdenum, or zinc. The organic compound layer may be arranged between the first electrode and the second electrode, and may be arranged in contact with the first electrode and the second electrode.

When the organic compound layer has a plurality of light-emitting layers, the organic compound layer may have an electric charge generation portion between the first light-emitting layer and the second light-emitting layer. The electric charge generation portion may have an organic compound with a Lowest Unoccupied Molecular Orbital energy (LUMO) of -5.0 eV or less. The same also applies to the case where the electric charge generation portion is included between the second light-emitting layer and the third light-emitting layer.

### Protective Layer

A protective layer may be provided on the second electrode. For example, by bonding glass provided with a moisture absorbent onto the second electrode, it is possible to reduce the penetration of water or the like with respect to the organic compound layer, and to reduce the occurrence of poor display. Alternatively, as another embodiment, a passivation film of silicon nitride or the like may be provided on the cathode, thereby reducing the penetration of water or the like with respect to the organic compound layer. For example, the following is also acceptable: the cathode is formed and then is transported to another chamber without breaking the vacuum, thereby forming a silicon nitride film with a thickness of 2 µm by the CVD method, resulting in a protective layer. After the deposition with the CVD method, a protective layer using the atomic layer deposition method (ALD method) may be provided. The material for the film with the ALD method has no restriction, and may be silicon nitride, silicon oxide, aluminum oxide, or the like. A silicon nitride may be further formed with the CVD method on the film formed with the ALD method. The film by the ALD method may have a smaller film thickness than that of the film formed by the CVD method. Specifically, the film thickness may be 50% or less, and further may be 10% or less.

### Color Filter

A color filter may be provided on the protective layer. For example, a color filter in view of the size of the organic light-emitting element is provided on another substrate. This and the substrate provided with the organic light-emitting element may be bonded with each other, or a color filter may be patterned using the photolithographic technology on the protective layer shown above. The color filter may include a high-molecular-weight compound.

### Planarization Layer

A planarization layer may be included between the color filter and the protective layer. The planarization layer is provided for the purpose of reducing the unevenness of the underlying layer. The planarization layer may be referred to as a material resin layer without restricting the purpose. The planarization layer may include an organic compound, may be a low-molecular-weight compound or a high-molecular-weight compound, and is preferably a high-molecular-weight compound.

The planarization layers may be provided on and under the color filter, and the constituent materials therefor may be the same or different. Specifically, mention may be made of a polyvinyl carbazole resin, a polycarbonate resin, a polyester resin, an ABS resin, an acrylic resin, a polyimide resin, a phenol resin, an epoxy resin, a silicon resin, a urine resin, and the like.

### Microlens

The organic light-emitting device may have an optical member such as a microlens on the light-emitting side thereof. The microlens can include an acrylic resin, an epoxy resin, or the like. The microlens may have the purpose of increasing the amount of light to be extracted from the organic light-emitting device, and controlling the direction of a light to be extracted. The microlens may have a shape of a hemisphere. When the microlens has a shape of a hemisphere, the tangents in contact with the hemisphere include the tangent in parallel with the insulation layer. The point of contact between the tangent and the hemisphere is the apex of the microlens. The apex of the microlens can also be determined in the same manner at a given cross-sectional view. In other words, the tangents in contact with the semicircle of the microlens in the cross-sectional view include the tangent in parallel with the insulation layer. The point of contact between the tangent and the semicircle is the apex of the microlens.

Further, the midpoint of the microlens can also be defined. In the cross-sectional view of the microlens, assuming the line segment from the point at which the shape of the circular arc ends to the point at which the shape of another circular arc ends, the midpoint of the line segment can be referred to as the midpoint of the microlens. The cross section for distinguishing between the apex and the midpoint may be the cross section perpendicular to the insulation layer.

The microlens has a first surface having a protruded portion, and a second surface opposed to the first surface. The second surface is preferably arranged closer to the functional layer side than the first surface. In order to assume such a configuration, the microlens is required to be formed on the light-emitting device. When the functional layer is an organic layer, the processes that involve high temperatures in the manufacturing process are preferably avoided. Further, when it is configured such that the second surface is arranged closer to the functional layer side than the first surface, the glass transition temperatures of the organic compounds configuring the organic layer are all preferably 100°C or more, and more preferably 130°C or more.

### Opposing Substrate

On the planarization layer, an opposing substrate may be included. The opposing substrate is provided at the position corresponding to the foregoing substrate, and hence is referred to as an opposing substrate. The constituent materials for the opposing substrate may be the same as those for the substrate. The opposing substrate may be a second substrate when the foregoing substrate is assumed to be the first substrate.

### Organic Layer

The organic compound layers (such as a hole injection layer, a hole transport layer, an electron block layer, a light-emitting layer, a hole block layer, an electron transport layer, and an electron injection layer) configuring the organic light-emitting element in accordance with the present Example are formed in the following manner.

The organic compound layers configuring the organic light-emitting element in accordance with the present Example can use dry processes such as a vacuum evaporation method, an ionizing evaporation method, sputtering, and plasma. Alternatively, in place of the dry process, a wet process for forming the layers by dissolution in an appropriate solvent, and a known coating method (e.g., spin coating, dipping, a cast method, a LB method, or an inkjet method) can be used.

Herein, when the layers are formed with the vacuum evaporation method, the solution coating method, or the like, crystallization or the like is less likely to occur, and the temporal stability is excellent. Further, in the case of the deposition with the coating method, the layers can also be formed by a combination with an appropriate binder resin.

As the binder resin, mention may be made of a polyvinyl carbazole resin, a polycarbonate resin, a polyester resin, an ABS resin, an acrylic resin, a polyimide resin, a phenol resin, an epoxy resin, a silicon resin, a urine resin, or the like. However, the present invention is not limited thereto.

Further, the binder resins may be used singly alone as a homopolymer or a copolymer, or may be used in combination of two or more thereof. Further, if required, known additives such as a plasticizer, an antioxidant, and an UV absorber may be used in combination.

### Pixel Circuit

The light-emitting device may have a pixel circuit connected with a light-emitting element. The pixel circuit may be of an active matrix type of each independently light-emission controlling the first light-emitting element and the second light-emitting element. The active matrix type circuit may be for voltage programming or current programing. The driving circuit has a pixel circuit for each pixel. The pixel circuit may have a light-emitting element, a transistor for controlling the light-emission brightness of a light-emitting element, a transistor for controlling the light-emission timing, a capacitance for holding the gate voltage of the transistor for controlling the light-emission brightness, and a transistor for establishing a connection to GND not via the light-emitting element.

The light-emitting device has a display region, and a peripheral region arranged in the periphery of the display region. The display region includes a pixel circuit, and the peripheral region includes a display control circuit. The mobility of the transistor configuring the pixel circuit may be smaller than the mobility of the transistor configuring the display control circuit.

The slope of the current voltage characteristic of the transistor configuring the pixel circuit may be smaller than the slope of the current voltage characteristic of the transistor configuring the display control circuit. The slope of the current voltage characteristic can be measured by the so-called Vg-Ig characteristic.

The transistor configuring the pixel circuit is the transistor connected with the light-emitting element such as the first light-emitting element.

### Pixel

The organic light-emitting device has a plurality of pixels. The pixels each have a sub-pixel for emitting a color mutually different from each other. The sub-pixel may have, for example, respective luminescent colors of RGB.

In the pixel, the region referred to as a pixel opening emits a light. This region is the same as the first region. The pixel opening may have a size of 15 µm or less, and may have a size of 5 µm or more. More specifically, the pixel opening may have a size of 11 µm, 9.5 µm, 7.4 µm, 6.4 µm or the like.

The distance between the sub-pixels may be 10 µm or less, and specifically, may be 8 µm, 7.4 µm, or 6.4 µm.

The pixel can assume a known arrangement form in a plan view. For example, a stripe arrangement, a delta arrangement, a PenTile arrangement, or a Bayer arrangement is acceptable. The shape in a plan view of the sub-pixel may assume any known shape. Examples thereof include a quadrangular shape such as a rectangle or a rhombus, and a hexagon. It is naturally understood that not a precise drawing but a shape close to a rectangle is included in a rectangle. The shape of the sub-pixel and the pixel array can be used in combination.

### Use of Organic EL Light-Emitting Element in Accordance with the Present Example

The organic EL light-emitting element in accordance with the present Example can be used as the constituent member for a display device or an illumination device. Other than this, the organic EL light-emitting element has uses such as the exposure light source of the image forming apparatus of an electrophotographic system, the backlight of a liquid crystal display device, a light-emitting device having a color filter for the white light source, and the like.

The display device may be an image information processing device having an image input portion for inputting image information from an area CCD, a linear CCD, a memory card, or the like, and having an information processing portion for processing the inputted information, and for displaying the inputted image at the display portion.

Further, the display portion included in an image pick-up device or an inkjet printer may have a touch panel function. The driving system of the touch panel function may be and infrared ray system, an electrostatic capacitance system, a resistance film system, or an electromagnetic induction system, and has no particular restriction. Further, the display device may be used for the display portion of a multifunction printer.

Next, with refence to the accompanying drawings, a display device in accordance with the present Example will be described.

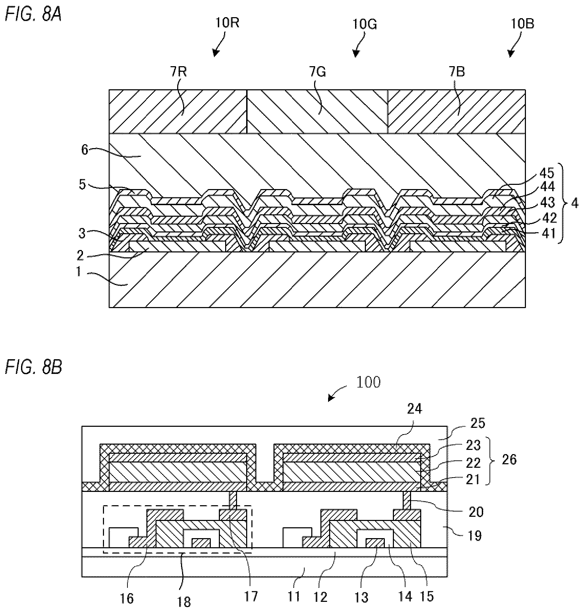

FIGS. 8A and 8B are each a cross-sectional schematic view showing an example of a display device having an organic light-emitting element and a transistor connected with the organic light-emitting element. The transistor is one example of an active element. The transistor may be a thin-film transistor (TFT).

FIG. 8A is one example of a pixel, i.e., the constituent element of the display device in accordance with the present embodiment. The pixel has a sub-pixel 10. The sub-pixel 10 is divided into 10R, 10G, and 10B according to the light emission. The luminescent color may be distinguished by the wavelength of the light emitted from the light-emitting layer, or the light emitted from the sub-pixel 10 may be subjected to selective transmission or color conversion by a color filter, or the like. Each sub-pixel 10 has a reflective electrode 2, i.e., the first electrode on the interlayer insulation layer 1, an insulation layer 3 covering the end of the reflective electrode 2, an organic compound layer 4 covering the first electrode and the insulation layer, a second electrode 5, a protective layer 6, and a color filter 7.

The interlayer insulation layer 1 may be provided with a transistor, and a capacitance element at the underlying layer or the inside thereof. The transistor and the first electrode may be electrically connected with each other via a contact hole not shown or the like.

The insulation layer 3 is also referred to as a bank, or a pixel isolation film. The insulation layer 3 covers the end of the first electrode, and is arranged surrounding the first electrode. The portion at which the insulation layer 3 is not arranged is in contact with the organic compound layer 4, and serves as a light-emitting region.

The organic compound layer 4 has a hole injection layer 41, a hole transport layer 42, a first light-emitting layer 43, a second light-emitting layer 44, and an electron transport layer 45.

The second electrode 5 may be a transparent electrode, a reflective electrode, or a semipermeable electrode.

The protective layer 6 reduces the penetration of the moisture to the organic compound layer 4. The protective layer 6 is shown as a monolayer, and may be a plurality of layers. An inorganic compound layer and an organic compound layer may be present layer by layer.

The color filter 7 is divided into 7R, 7G, and 7B by the color. The color filter 7 may be formed on a planarization film not shown. Further, a resin protective layer not shown may be included on the color filter 7. Further, the color filter 7 may be formed on the protective layer 6. Alternatively, the color filter 7 may be provided on an opposing substrate such as a glass substrate, followed by bonding.

For a display device 100 of FIG. 8B, the organic light-emitting element 26 and a TFT 18 as one example of the transistor are described. A substrate 11 of glass, silicon, or the like and an insulation layer 12 thereon are provided. On the insulation layer 12, an active element 18 such as TFT is arranged, and a gate electrode 13 of an active element, a gate insulation film 14, and a semiconductor layer 15 are arranged. The TFT 18 additionally includes a semiconductor layer 15, a drain electrode 16, and a source electrode 17. At the top of the TFT 18, an insulation film 19 is provided. An anode 21 configuring an organic light-emitting element 26 and a source electrode 17 are connected with each other via a contact hole 20 provided in the insulation film 19.

Incidentally, the system of electric connection between the electrode (the anode or the cathode) included in the organic light-emitting element 26 and the electrode (the source electrode or the drain electrode) included in the TFT is not limited to the aspect shown in FIG. 8B. In other words, it is essential only that any one of the anode or the cathode and any one of the TFT source electrode or drain electrode are electrically connected with each other. The TFT indicates a thin-film transistor.

For a display device 100 of FIG. 8B, the organic compound layer 22 is shown as if it were one layer, and the organic compound layer 22 may be a plurality of layers. On the cathode 23, a first protective layer 24 and a second protective layer 25 for reducing the deterioration of the organic light-emitting element 26 are provided.

For the display device 100 of FIG. 8B, although a transistor is used as a switching element, another switching element may be used in place of this.

Further, the transistor for use in the display device 100 of FIG. 8B is not limited to the transistor using a single crystal silicon wafer, and may be a thin-film transistor having an active layer on the insulating surface of the substrate. As the active layers, mention may be made of single crystal silicon, amorphous silicon, non-single crystal silicon such as microcrystalline silicon, non-single crystal oxide semiconductor such as indium zinc oxide or indium gallium zinc oxide, or the like. Incidentally, a thin-film transistor is also referred to as a TFT element.

The transistor included in the display device 100 of FIG. 8B may be formed in a substrate such as a Si substrate. Herein, the wording "being formed in the substrate" means that the substrate such as a Si substrate itself is processed, thereby manufacturing a transistor. In other words, the inclusion of a transistor in a substrate can also be regarded as the substrate and the transistor being integrally formed.

The organic light-emitting element in accordance with the present embodiment is controlled on the light-emission brightness by a TFT of one example of the switching element, and can display an image by respective light-emission brightnesses due to provision of organic light-emitting elements in a plurality of planes. Incidentally, the switching element in accordance with the present embodiment is not limited to a TFT, and may also be a transistor formed of low-temperature polysilicon, or an active matrix driver formed on a substrate such as a Si substrate. The term "on the substrate" can also be said as "in the substrate". Whether a transistor is provided in a substrate, or a TFT is used is selected according to the size of the display portion. For example, when the size is about 0.5 inch, an organic light-emitting element is preferably provided on a Si substrate.

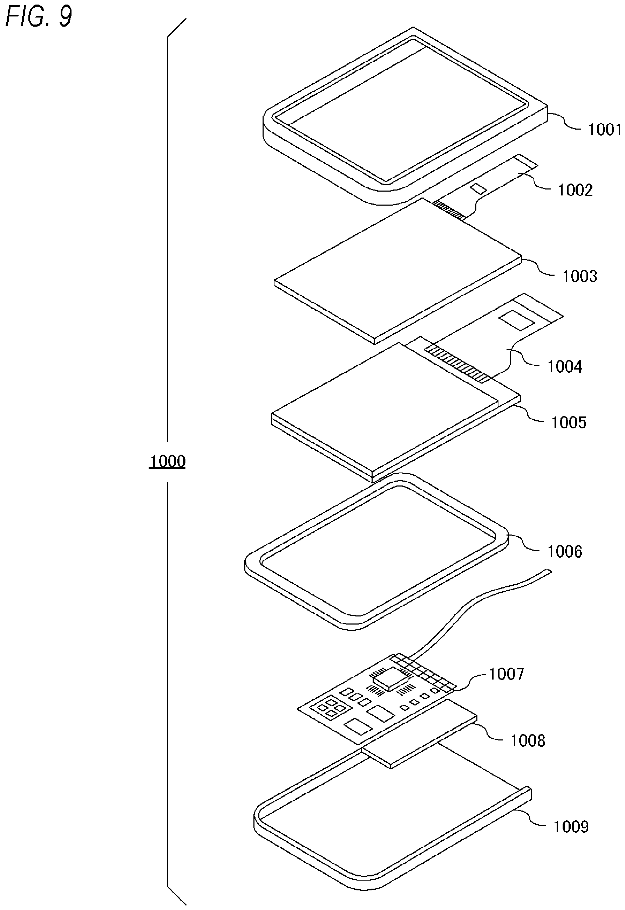

FIG. 9 is a schematic view showing one example of a display device in accordance with the present embodiment. A display device 1000 may have a touch panel 1003, a display panel 1005, a frame 1006, a circuit substrate 1007, and a battery 1008 between an upper cover 1001 and a lower cover 1009. The touch panel 1003 and the display panel 1005 are connected with flexible print circuits FPC 1002 and 1004, respectively. A transistor is printed on the circuit substrate 1007. The battery 1008 is not required to be provided unless the display device is portable equipment, or may be provided at a different position even when the display device is portable equipment.

The display device in accordance with the present embodiment may have color filters having red, green, and blue colors. The color filters may be arranged with the red, green, and blue colors in a delta array.

The display device in accordance with the present embodiment may be used for the display portion of a portable terminal. In that case, the display device may have both of the display function and the operation function. As the portable terminal, mention may be made of a portable phone such as a smartphone, a tablet, a head mount display, or the like.

The display device in accordance with the present embodiment may be used for the display portion of an image pick-up device having an optical portion having a plurality of lenses, and an image pick-up element for receiving a light transmitted through the optical portion. The image pick-up device may have a display portion for displaying information acquired by the image pick-up element. Further, the display portion may be a display portion exposed outside the image pick-up device, or a display portion arranged in the finder. The image pick-up device may be a digital camera or a digital video camera.

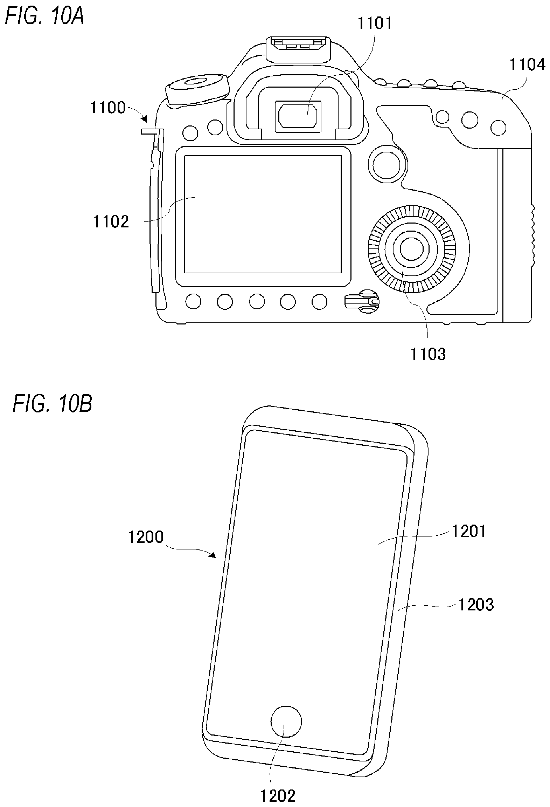

FIG. 10A is a schematic view showing one example of an image pick-up device in accordance with the present embodiment. An image pick-up device 1100 may have a view finder 1101, a back-surface display 1102, an operation portion 1103, and a housing 1104. The view finder 1101 may have a display device in accordance with the present embodiment. In that case, the display device may display not only an image to be picked up, but also environmental information, an image pick-up instruction, and the like. The environmental information may be the intensity of natural light, the direction of natural light, the moving speed of a subject, the possibility of shielding of a subject by a shield, and the like.

The timing suitable for image pick-up is a short time. For this reason, the information is desirably displayed as soon as possible. Therefore, the display device using the organic light-emitting element of the present invention is preferably used. This is because the organic light-emitting element has a high response speed. Compared with the liquid crystal display devices, the display device using the organic light-emitting element can be used more preferable for the devices demanded to have a display speed.

The image pick-up device 1100 has an optical portion not shown. The optical portion has a plurality of lenses, and forms an image on the image pick-up element accommodated in the housing 1104. The plurality of lenses can adjust the focus by adjusting the relative positions. This operation can also be automatically performed. The image pick-up device may be referred to as a photoelectric conversion device. The photoelectric conversion device can include not the method of sequential image pick-up, but the method in which the difference from the previous image is detected, the method of cutting out from the continuously recorded images, and other methods as the image pick-up methods.

FIG. 10B is a schematic view showing one example of electronic equipment in accordance with the present embodiment. Electronic equipment 1200 has a display portion 1201, an operation portion 1202, and a housing 1203. The housing 1203 may have a circuit, a print substrate having the circuit, a battery, and a communication portion. The operation portion 1202 may be a button, or a reaction portion of a touch panel system. The operation portion may be a biometric recognition portion of recognizing a fingerprint, and performing release of locking, and the like. The electronic equipment having the communication portion can also be said to be communication equipment. The electronic equipment may further have a camera function by including a lens and an image pick-up element. The image picked up by the camera function is projected on the display portion. The electronic equipment includes a smartphone, a note personal computer, or the like.

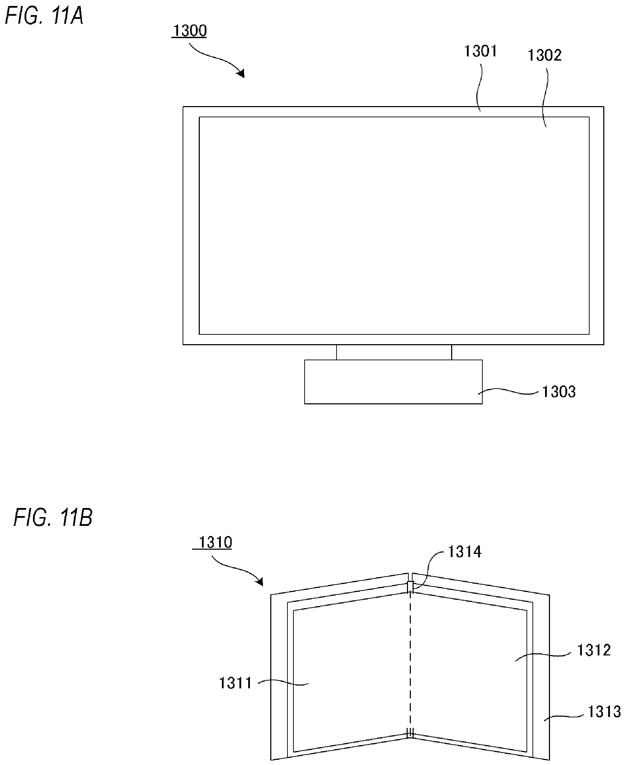

FIGS. 11A and 11B are each a schematic view showing one example of a display device in accordance with the present embodiment. FIG. 11A is a display device such as a television monitor or a PC monitor. A display device 1300 has a frame 1301, and has a display portion 1302. For the display portion 1302, a light-emitting device in accordance with the present embodiment may be used.

The display device 1300 has a frame 1301 and a foundation 1303 for supporting the display portion 1302. The foundation 1303 is not limited to the form of FIG. 11A. The lower side of the frame 1301 may also serve as the foundation.

Further, the frame 1301 and the display portion 1302 may be curved. The radius of curvature thereof may be at least 5000 mm and not more than 6000 mm.

FIG. 11B is a schematic view showing another example of the display device in accordance with the present embodiment. The display device 1310 of FIG. 11B is configured bendably, and is a so-called foldable display device. The display device 1310 has a first display portion 1311, a second display portion 1312, a housing 1313, and a bending point 1314. The first display portion 1311 and the second display portion 1312 may have the light-emitting device in accordance with the present embodiment. The first display portion 1311 and the second display portion 1312 may be a seamless one display device. The first display portion 1311 and the second display portion 1312 can be divided at the bending point. The first display portion 1311 and the second display portion 1312 may display respectively different images, or may display one image at the first and second display portions.

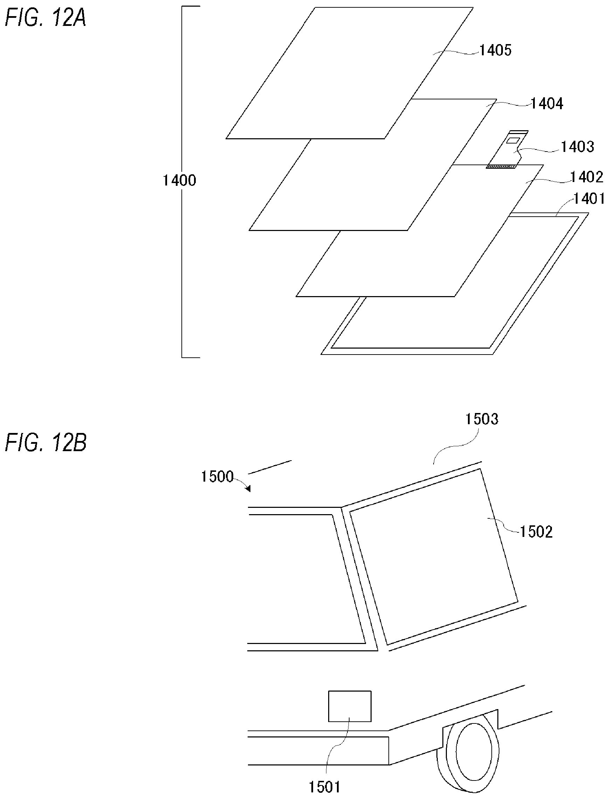

FIG. 12A is a schematic view showing one example of an illumination device in accordance with the present embodiment. An illumination device 1400 may have a housing 1401, a light source 1402, a circuit substrate 1403, an optical film 1404, and an optical diffusion portion 1405. The light source 1402 may have an organic light-emitting element in accordance with the present embodiment. An optical filter may be a filter for improving the color rendering properties of the light source. The optical diffusion portion 1405 can perform illumination, or the like, or can effectively diffuse a light from a light source, and can deliver a light to a wide range. The optical filter and the optical diffusion portion 1405 may be provided at the light-emitting side of the illumination. If required, a cover may be provided at the outermost portion.

An illumination device is, for example, a device for illuminating the interior of a room. The illumination device may emit a light of any color of a white color, a neutral white color, and additionally, from blue to red colors. The illumination device may have a light modulation circuit for modulating a light thereof. The illumination device may have the organic light-emitting element of the present invention, and a power supply circuit connected therewith. The power supply circuit is a circuit for converting an alternating voltage to a direct current voltage. Further, white has a color temperature of 4200 K, and neutral white has a color temperature of 5000 K. The illumination device may have a color filter.

Further, the illumination device in accordance with the present embodiment may have a heat radiation portion. The heat radiation portion radiates the heat in the device to outside the device. Mention may be made of a metal with a high specific heat, liquid silicon, or the like.

FIG. 12B is a schematic view of a car of one example of a mobile unit in accordance with the present embodiment. The car has a tail lamp of one example of a lighting fixture. A car 1500 has a tail lamp 1501, and may be in a form of turning on a tail lamp when a braking operation or the like is performed.

The tail lamp 1501 may have the organic light-emitting element in accordance with the present embodiment. The tail lamp 1501 may have a protective member for protecting the organic EL element. The protective member may use any material so long as the material has a strength high to a certain degree, and is transparent, and the protective member is preferably formed of polycarbonate or the like. Polycarbonate may be mixed with a flange carboxylic acid derivative, an acrylonitrile derivative, or the like.

The car 1500 may have a car body 1503 and a window 1502 mounted thereon. The window may be a transparent display unless it is a window for checking the front and rear of the car. The transparent display may have the organic light-emitting element in accordance with the present embodiment. In this case, the constituent materials such as the electrode included in the organic light-emitting element each include a transparent member.

The mobile unit in accordance with the present embodiment has a drive member such as an engine or a motor, and a moving means such as a wheel, a propeller, or a tire. Specifically, the mobile unit may be a car, a ship, an aircraft, a drone, a bicycle, a rail vehicle, or the like. The mobile unit may have an airframe and a lighting fixture provided on the airframe. The lighting fixture may emit a light for informing the position of the airframe. The lighting fixture has the organic light-emitting element in accordance with the present embodiment.

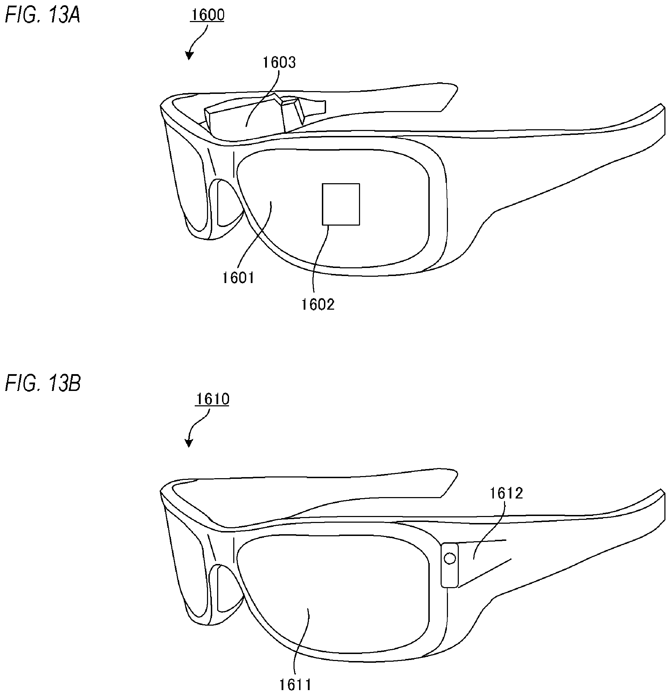

Referring to FIGS. 13A and 13B, an application example of the display device of each of the embodiments will be described. The display device is applicable to, for example, a system mountable as a wearable device such as smart glasses, a HMD, or a smart contact. The image pick-up display device for use in such an application example has an image pick-up device capable of photoelectrically converting a visible light, and a display device capable of emitting a visible light.

FIG. 13A illustrates glasses 1600 (smart glasses) in accordance with one application example. An image pick-up device 1602 such as a CMOS sensor or a SPAD is provided on the front surface side of a lens 1601 of the glasses 1600. Further, on the back surface side of the lens 1601, the display device of each of the embodiments is provided.

The glasses 1600 further include a control device 1603. The control device 1603 functions as a power supply for supplying an electric power to the image pick-up device 1602 and the display device in accordance with each embodiment. Further, the control device 1603 controls the operations of the image pick-up device 1602 and the display device. At the lens 1601, an optical system for collecting a light to the image pick-up device 1602 is formed.

FIG. 13B illustrates the glasses 1610 (smart glasses) in accordance with one application example. The glasses 1610 have a control device 1612. On the control device 1612, the image pick-up device corresponding to the image pick-up device 1602 and a display device are mounted. At the lens 1611, an optical system for projecting the luminescence emitted by the display device in the control device 1612 is formed, so that an image is projected on the lens 1611. The control device 1612 functions as a power supply for supplying an electric power to the image pick-up device and the display device, and controls the operations of the image pick-up device and the display device. The control device may have a line-of-sight detection portion for detecting the line of sight of a wearer. For the detection of a line of sight, an infrared radiation may be used. The infrared radiation emitting portion emits an infrared light with respect to a user's eyeball carefully observing the display image. The reflected light from the eyeball of the emitted infrared light is detected by the image pick-up portion having a photo acceptance unit, resulting in a picked-up image of the eyeball. Inclusion of a reducing means of reducing a light from the infrared radiation emitting portion to the display portion in a plan view reduces the reduction of the appearance of the image.

The user's line of sight with respect to the display image is detected from the picked-up image of the eyeball obtained by image pick-up of an infrared light. To the detection of the line of sight using the picked-up image of the eyeball, a given known method is applicable. As one example, the line-of-sight detection method on the basis of the Purkinje image due to reflection of an emitted light at the cornea can be used.

More specifically, the line-of-sight detection processing on the basis of the pupil cornea reflection method is performed. The line-of-sight vector indicative of the orientation (rotation angle) of the eyeball is calculated on the basis of the pupil image included in the picked-up image of the eyeball and the Purkinje image using the pupil cornea reflection method, thereby detecting the user's line of sight.

The display device in accordance with one embodiment of the present invention has an image pick-up device having a photo acceptance unit, and may control the display image of the display device on the basis of the user's line-of-sight information from the image pick-up device.

Specifically, for the display device, a first display region carefully observed by a used and a second display region other than the first display region are determined on the basis of the line-of-sight information. The first display region and the second display region may be determined by the control device of the display device, or the one determined by an external control device may be received. In the display region of the display device, the display resolution of the first display region may be controlled higher than the display resolution of the second display region. In other words, the resolution of the second display region may be set lower than that of the first display region.

Further, the display region has a first display region and a second display region different from the first display region, and the region with a higher priority is determined from the first display region and the second display region on the basis of the line-of-sight information. The first display region and the second display region may be determined by the control device of the display device, or the one determined by an external control device may be received. The resolution of the region with a higher priority may be controlled higher than the resolutions of other regions than the region with a higher priority. In other words, the resolution of the region with a relatively lower priority may be set lower.

Incidentally, for the determination of the first display region and the region with a higher priority, AI may be used. AI may be a model configured such as to estimate the angle of the line of sight from the image of the eyeball and the distance to the object beyond the line of sight with the image of the eyeball and the direction in which the eyeball of the image has been actually looking as the training data. An AI program may be included in the display device, may be included in the image pick-up device, or may be included in an external device. When the AI program is included in an external device, it is transmitted to the display device via communication.

When display control is performed on the basis of visual observation detection, the present invention is preferably applicable to smart glasses further having an image pick-up device for image-picking up the outside. Smart glasses can display the picked-up outside information in real time.

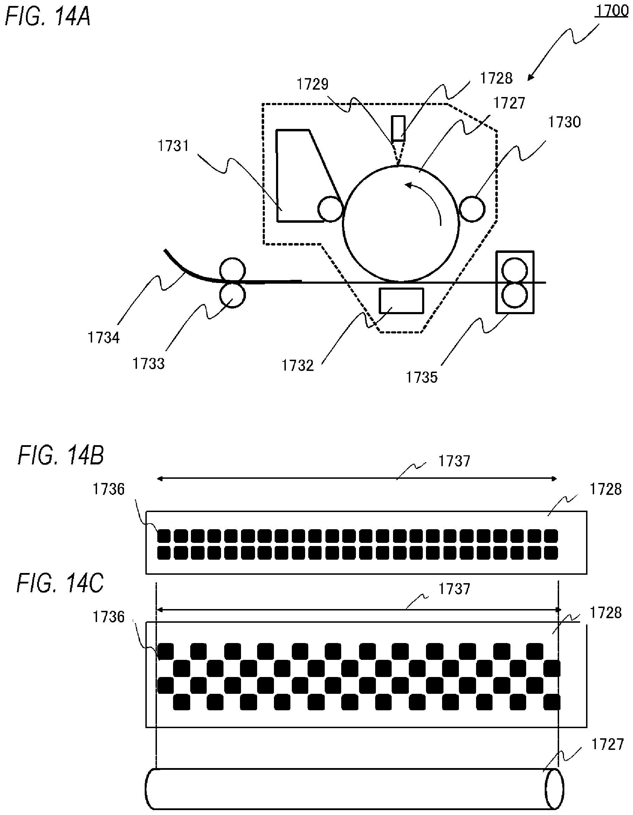

FIGS. 14A and 14B each show an image forming apparatus in accordance with one embodiment of the present invention. FIG. 14A is a schematic view of an image forming apparatus 1700 in accordance with one embodiment of the present invention. The image forming apparatus 1700 has a photosensitive member, an exposure light source, a development portion, a charging portion, a transfer unit, a conveying roller, and a fixing unit.

A light 1729 is applied from an exposure light source 1728, and an electrostatic latent image is formed on the surface of the photosensitive member 1727. The exposure light source has an organic light-emitting element in accordance with the present invention. A development portion 1731 has a toner or the like. A charging portion 1730 charges the photosensitive member. A transfer unit 1732 transfers the developed image onto a recording medium 1734. A conveying portion 1733 conveys a recording medium 1734. The recording medium 1734 is, for example, paper. A fixing portion 1735 fixes the image formed on the recording medium 1734.

FIGS. 14B and 14C are each a schematic view showing a state in which a plurality of light-emitting portions 1736 are arranged on a long substrate in an exposure light source 1728. A ref No. 1737 indicates the direction in parallel with the axis of the photosensitive member, and indicates the array direction in which the organic light-emitting elements are arrayed. The array direction is the same as the direction of the axis around which the photosensitive member 1727 rotates. This direction can also be referred to as the major axis direction of the photosensitive member.

FIG. 14B is a form in which the light-emitting portion is arranged along the major axis direction of the photosensitive member. FIG. 14C is a different form from that of FIG. 14B, and is a form in which the light-emitting portions are arranged alternately respectively in the first column and the second column in the column direction. The first column and the second column are arranged at different positions in the row direction.

At the first column, a plurality of light-emitting portions are arranged spaced at intervals. The second column has a light-emitting portion at each position corresponding to the interval between the light-emitting portions of the first column. Namely, a plurality of light-emitting portions are also arranged spaced at intervals in the row direction.

The arrangement of FIG. 14C can also be paraphrased as, for example, an arrangement in a lattice shape, an arrangement in a houndstooth check, or an arrangement in a checkerboard pattern.

As described up to this point, use of a device using the organic light-emitting element in accordance with the present embodiment enables display with a good image quality and stable even for a long-time display.

### Other Examples

In the above description, Examples using an organic EL element as the light-emitting element have been described. However, the present invention is also applicable to a light-emitting device using other light-emitting elements than the organic EL element. Also with the light-emitting device using other light-emitting elements than the organic EL element, the pad electrode is exposed to etching only once at the time of etching the sealing layer. As a result, it is possible to reduce the etched amount of the pad electrode. As a result of this, for example, it is possible to obtain high reliability with respect to the corrosion of the pad electrode due to immersion in water for a long time at a dicing step of a mounting process.

In accordance with the present disclosure, it is possible to improve the reliability of the pad of a light-emitting device.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A light-emitting device comprising:
a pixel region including a plurality of light-emitting elements; and
a peripheral region including an electrode terminal for establishing an electrical connection with an external terminal, a first insulation layer arranged on the electrode terminal, and a second insulation layer arranged on the first insulation layer, wherein
the electrode terminal includes a first metal layer exposed by a first opening provided in the first insulation layer,
an upper surface of an end portion of the first insulation layer is inclined with respect to a bottom surface of the first metal layer, the upper surface of the end portion forming a part of the first opening,
the second insulation layer has a second opening in the first opening, and
the second insulation layer is in contact with the electrode terminal in the first opening.

2. The light-emitting device according to claim 1, wherein
the second insulation layer functions as a sealing layer.

3. The light-emitting device according to claim 2, wherein
an upper surface of the sealing layer has a portion inclined with respect to the first metal layer.

4. The light-emitting device according to claim 2 or 3, wherein
the upper surface of the sealing layer is in parallel with the first metal layer in a region adjacent to the first opening.

5. The light-emitting device according to any one of claims 2 to 4, wherein
the sealing layer has a 3-layered structure in which an oxide film layer is sandwiched between insulation layers.

6. The light-emitting device according to any one of claims 1 to 5, wherein
an end portion of the first insulation layer is separated from the second opening in a plan view.

7. The light-emitting device according to any one of claims 1 to 6, further comprising a second metal layer arranged on the first metal layer, wherein
the first insulation layer is arranged on the second metal layer.

8. The light-emitting device according to claim 7, wherein
the second metal layer and the second insulation layer are in contact with each other in the first opening.

9. The light-emitting device according to any one of claims 1 to 8, wherein
an inclination of the first insulation layer with respect to the first metal layer has an angle of inclination of at least 20 degrees and not more than 50 degrees.

10. The light-emitting device according to any one of claims 1 to 9, wherein
the second insulation layer has a first inclined portion having an upper surface inclined with respect to the first metal layer, a parallel portion having an upper surface in parallel with the first metal layer, and a second inclined portion having an upper surface inclined with respect to the first metal layer.

11. The light-emitting device according to any one of claims 2 to 5, wherein
a moisture transmittance of the first insulation layer is larger than a moisture transmittance of the sealing layer.

12. The light-emitting device according to any one of claims 1 to 11, wherein
the first metal layer has a concave portion at a portion of the second opening, and a depth of the concave portion is at least 1 nm and not more than 100 nm.

13. The light-emitting device according to any one of claims 1 to 12, wherein
the light-emitting element is an organic EL light-emitting element.

14. A display device comprising a display panel including the light emitting device according to any one of claims 1 to 13, a frame provided with the display panel and a circuit substrate.

15. A photoelectric conversion device comprising an optical unit including a plurality of lenses, an image sensor configured to receive light having passed through the optical unit, and a display unit configured to display an image captured by the image sensor,
wherein the display unit includes a light emitting device according to any one of claims 1 to 13.

16. An electronic apparatus comprising:
a display unit including a light emitting device according to any one of claims 1 to 13;
a housing provided with the display unit; and
a communication unit provided in the housing and configured to perform external communication.

17. An illumination device comprising:
a light source including a light emitting device according to any one of claims 1 to 13; and
a light-diffusing unit or an optical film configured to pass light generated by the light source.

18. A moving body comprising:
a lighting appliance including a light emitting device according to any one of claims 1 to 13; and
a main body provided with the lighting appliance.

19. A device comprising:
an image pick-up device provided on a front surface side of a lens;
a display device including a light-emitting device according to any one of claims 1 to 13, on a back surface side of the lens.

20. An image forming apparatus comprising:
a photosensitive member,
an exposure light source opposed to the photosensitive member, the exposure light source including the light-emitting device according to any one of claims 1 to 13.

21. A method for manufacturing a light-emitting device, the method comprising the steps of:
forming a metal portion including a first metal layer;
forming a first insulation layer on the metal portion;
forming a first opening in the first insulation layer by isotropic etching the first insulation layer;
forming a second insulation layer on the first insulation layer and the first metal layer; and
forming a second opening in the second insulation layer by anisotropic etching the second insulation layer, thereby exposing the first metal layer at the second opening.

22. The method for manufacturing a light-emitting device according to claim 21, the method further comprising a step of forming a second metal layer on the first metal layer, wherein
in the step of forming the first opening in the first insulation layer, the first insulation layer is isotropic etched, with the second metal layer being an etching stop layer.

23. The method for manufacturing a light-emitting device according to claim 22, further comprising the step of,
after anisotropic etching the second insulation layer, etching the second metal layer, thereby exposing the first metal layer at the second opening.
